# EUROPÄISCHE PATENTANMELDUNG

(11) **EP 1 266 975 A1**
(43) Veröffentlichungstag der Anmeldung: **18.12.2002**
(21) Anmeldenummer: 01810612.0
(22) Anmeldetag: 22.06.2001
(51) Int. Cl.: C22C 12/00, B23K 35/26

(54) **Bleifreies Lötmittel**

(30) Priorität: 12.06.2001 EP 01810566
(71) Anmelder: ESEC Trading SA, 6330 Cham (CH)
(72) Erfinder: Arsalane, Souad, Dr., 6353 Weggis (CH); Lambracht, Petra, 64807 Dieburg (DE); Rettenmayr, Markus, Dr., 64293 Darmstadt (DE); Tschudin, Christoph, 8055 Zürich (CH)
(74) Vertreter: Falk, Urs, Dr.

(57) **Zusammenfassung**

Die Erfindung betrifft ein bleifreies Lötmittel bestehend aus einer Legierung auf Wismutbasis. Das bleifreie Lötmittel weist einen Anteil von wenigstens 80 Gewichtsprozent Wismut und eine Solidustemperatur von wenigstens 260°C auf.

## Beschreibung

Die Erfindung betrifft ein bleifreies Lötmittel.

Lötmittel werden in vielfältigen Ausführungen bei der Montage von elektrischen und elektronischen Komponenten, insbesondere Leiterplatten eingesetzt. Derartige elektrische Komponenten sind von diskreten Bauelementen, insbesondere Widerständen, Kondensatoren, Dioden und Transistoren gebildet.

Im Zuge der Miniaturisierung von elektronischen Produkten sind die zugehörigen elektronischen Schaltungen in integrierten Schaltungen (IC) integriert. Derartige integrierte Schaltungen weisen eine hohe Integrationsdichte von elektrischen Schaltungen und Anschlüssen auf. Zudem werden die einzelnen integrierten Schaltungen in hoher Packungsdichte auf Leiterplatten oder dergleichen aufgebracht, wobei die Leiterplatten selbst aus einer hohen Anzahl von Leitungsebenen bestehen.

Zum Anlöten von integrierten Schaltkreisen auf derartige Leiterplatten verbleibt nur noch ein äusserst geringer Raum, in welchem das Lötmittel exakt positioniert werden muss.

Dabei werden zudem an das Lötmittel erhebliche mechanische Anforderungen gestellt. Insbesondere muss das Lötmittel resistent gegen Scher- und Druckkräfte sein. Zudem muss das Lötmittel eine gute thermische Ermüdungsfestigkeit aufweisen, das heisst das Lötmittel muss unempfindlich gegenüber Volumenänderungen bei starken Temperaturschwankungen sein.

Diese Anforderungen werden von Lötmitteln erfüllt, welche als Hauptbestandteil Blei enthalten. Insbesondere zur elektrischen Kontaktierung von elektronischen Bauelementen auf Leiterplatten werden als Lötmittel Legierungen des Typs PbSn(x)Ag(y) eingesetzt. Derartige Lötmittel weisen Solidustemperaturen auf, die oberhalb von 260°C liegen. Damit eignen sich derartige Lötmittel insbesondere auch zur Kontaktierung von Leistungshalbleitern, bei deren Betrieb eine beträchtliche Wärmeentwicklung entsteht.

Ein wesentlicher Nachteil derartiger Lötmittel besteht darin, dass das Blei in diesen Lötmitteln stark toxische Eigenschaften aufweist und damit eine Gefährdung für die menschliche Gesundheit darstellt. Damit sind bei der Entsorgung von Bauteilen mit bleihaltigen Lötmitteln strenge Sicherheitsmassnahmen zu treffen. Die Entwicklung der Gesetzgebung geht dabei dahin, die Anforderungen für die Entsorgung derartiger Stoffe hoch anzusetzen.

Daher ist versucht worden, derartige bleihaltige Lötmittel durch bleifreie Lötmittel zu ersetzen.

Derartige bleifreie Lötmittel sind typischerweise von Legierungen auf Zinnbasis gebildet.

Problematisch hierbei ist jedoch, dass derartige zinnbasierte Lötmittel eine geringe Solidustemperatur aufweisen.

Zudem weisen derartige Lötmittel unbefriedigende mechanische Eigenschaften auf. Insbesondere weisen derartige Lötmittel eine unzureichende Verformbarkeit, Festigkeit und Dauerhaltbarkeit bei thermischen Belastungen auf.

In der DE 195 38 992 A1 wird ein bleifreies Lötmittel vorgeschlagen, welches hinsichtlich dieser mechanischen Eigenschaften verbessert ist. Dieses Lötmittel besteht aus einer Legierung, die effektive Mengen von Wismut-Zinn und Gold aufweist. Dabei weist die Legierung eine Schmelztemperatur von etwa 138°C auf. Die Legierung besteht vorzugsweise aus einem Masseanteil von 42% Zinn, einem Masseanteil von weniger als 1% Gold und einem Masseanteil von etwa 58% Wismut.

Nachteilig bei diesem Lötmittel ist jedoch, dass aufgrund der geringen Schmelztemperatur ein Einsatz zur Kontaktierung von elektronischen Schaltkreisen und insbesondere Leistungshalbleitern nicht oder nur äusserst eingeschränkt möglich ist. Insbesondere die starke Wärmeentwicklung bei Leistungshalbleitern verhindert einen Einsatz von derartigen Lötmitteln.

Aus der WO 9747425 ist ein bleifreies Lötmittel bekannt, welches aus einer Legierung aus Zinn, Wismut und Silber besteht. Der Zinnanteil der Legierung liegt zwischen 70% und 93%. Zudem enthält das Lötmittel 5% bis 27,5% Wismut und 2% bis 7,5% Silber. Die in Pulverform vorliegende Legierung wird insbesondere zur Herstellung von Lötpasten verwendet.

In der EP 826458 ist ein bleifreies Lötmittel auf Zinnbasis beschrieben. Das Lötmittel enthält als weitere Komponenten Silber mit einem Anteil von 3% bis 4%, Wismut mit einem Anteil von 2% bis 6% und Indium mit einem Anteil von 2% bis 6%. Die Solidustemperatur dieser Lötmittellegierung liegt maximal bei 211°C.

Der Erfindung liegt die Aufgabe zugrunde ein bleifreies Lötmittel mit hoher thermischer und mechanischer Belastbarkeit bereitzustellen.

Zur Lösung dieser Aufgabe sind die Merkmale des Anspruchs 1 vorgesehen. Erfindungsgemässe Verwendungen des Lötmittels sind in den Ansprüchen 14 und 15 beschrieben. Vorteilhafte Ausführungsformen und zweckmässige Weiterbildungen der Erfindung sind in den Unteransprüchen beschrieben.

Das erfindungsgemässe, bleifreie Lötmittel besteht aus einer Legierung auf Wismutbasis mit einem Anteil von wenigstens 80 Gewichtsprozent Wismut und mit einer Solidustemperatur von wenigstens 260°C.

Da das erfindungsgemässe Lötmittel keine Bleianteile enthält, ist es äusserst umweltverträglich.

Dabei weist das erfindungsgemässe Lötmittel eine hohe Solidustemperatur auf, die einen Einsatz des Lötmittels zur Kontaktierung von integrierten Schaltungen ermöglicht.

Die bei mindestens 260°C liegende Solidustemperatur liegt in einem Bereich, in welchem üblicherweise nur Solidustemperaturen bleihaltiger Lötmittel liegen. Die Liquidustemperatur des erfindungsgemässen Lötmittels liegt vorzugsweise unterhalb 450°C. Aufgrund dieser thermischen Eigenschaften ist das erfindungsgemässe Lötmittel in einer äusserst grossen Bandbreite bei der Kontaktierung elektronischer Bauelemente, insbesondere hochintegrierter Schaltungen einsetzbar.

Insbesondere eignet sich das erfindungsgemässe Lötmittel zur Kontaktierung von Leistungshalbleitern, bei deren Betrieb erhebliche Wärmemengen freigesetzt werden.

Das erfindungsgemässe Lötmittel kann insbesondere für moderne Löttechniken verwendet werden, die bei der Kontaktierung hochintegrierter Schaltungen eingesetzt werden. Hierzu gehören insbesondere Flip-Chip-Verbindungstechniken und sogenannte Die-attach-Techniken, bei welchen Chips und dergleichen mittels des Lötmittels auf ein Substrat zur mechanischen Kontaktierung aufgebracht werden.

Bei derartigen Löttechniken werden erhöhte Anforderungen an das Lötmittel hinsichtlich seiner thermischen und mechanischen Eigenschaften gestellt.

Hierzu gehört insbesondere die thermische Ermüdungsfestigkeit des Lötmittels. Je grösser die Ermüdungsfestigkeit des Lötmittels ist, desto grösser ist dessen Resistenz gegenüber mechanischen Verformungen, die durch starke Temperaturschwankungen hervorgerufen werden.

Ein weiterer wesentlicher Parameter ist die Benetzbarkeit des Lötmittels. Je besser die Benetzbarkeit des Lötmittels ist, desto besser kann dieses auf die Oberfläche eines Substrates aufgebracht werden. Dieser Parameter ist insbesondere bei der elektrischen Kontaktierung von hochintegrierten Schaltungen von Bedeutung, da in derartigen Anwendungsfällen äusserst kleine Lötmengen positionsgenau auf einem Substrat aufgebracht werden müssen. Dabei muss gewährleistet sein, dass diese geringen Lötmengen eine grosse Haltfestigkeit auf dem Substrat aufweisen. Hierfür ist insbesondere eine grosse Benetzbarkeit des Lötmittels von Bedeutung.

Weitere mechanische Parameter des Lötmittels sind dessen Scherfestigkeit und Biegefestigkeit. Dies bedeutet, dass bei Krafteinwirkungen auf die mittels des Lötmittels auf einem Substrat befestigten elektronischen Bauelemente das Lötmittel durch Biegekräfte oder Scherkräfte nicht beschädigt werden darf. Schliesslich bildet die Festigkeit des Lötmittels einen wesentlichen mechanischen Parameter.

Das erfindungsgemässe Lötmittel weist hinsichtlich dieser thermischen und mechanischen Eigenschaften gute Werte auf, so dass das Lötmittel eine hohe Resistenz gegen thermische und mechanische Belastungen aufweist.

Die thermischen und mechanischen Eigenschaften sind durch die Wahl weiterer Lötmittelkomponenten flexibel und reproduzierbar vorgebbar.

Insbesondere können in einer vorteilhaften Ausführungsform der Erfindung durch Zugabe von Silber die thermischen und mechanischen Eigenschaften des Lötmittels verändert werden.

Dabei hat sich gezeigt, dass mit steigendem Silbergehalt die mechanischen Eigenschaften des erfindungsgemässen Lötmittels verbessert werden. Insbesondere wird durch Erhöhung des Silbergehalts die Benetzbarkeit des Lötmittels erhöht. Auch die Verformbarkeit des Lötmittels wird durch die Zugabe von Silber erhöht.

Das erfindungsgemässe Lötmittel wird insbesondere zur Herstellung von Halbzeugen wie zum Beispiel Pasten, Drähten und Bändern verwendet.

Durch die gute Verformbarkeit des erfindungsgemässen Lötmittels, insbesondere bei silberhaltigen Legierungen auf Wismutbasis, sind diese Halbzeuge mit hoher Qualität einfach herstellbar. Insbesondere ist eine gute mechanische Bearbeitbarkeit derartiger Halbzeuge gewährleistet. Beispielsweise wird bei Drähten, die mit dem erfindungsgemässen Lötmittel hergestellt sind, eine gute Aufspulbarkeit erhalten. Weiterhin wird durch die hohe Bruchdehnung des erfindungsgemässen Lötmittels ein gutes Handling der Halbzeuge, insbesondere der Drähte und Bänder erhalten.

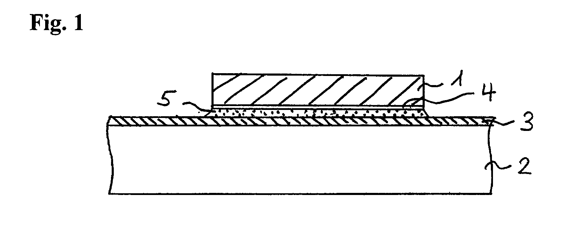

Die Erfindung wird nachfolgend anhand von Ausführungsbeispielen und einer Zeichnung erläutert. Die einzige Figur 1 zeigt eine schematische Darstellung eines Halbleiterchips, der mittels des erfindungsgemässen Lötmittels auf einem Substrat kontaktiert ist.

Die Figur 1 zeigt schematisch einen Halbleiterchip 1, der auf einem Substrat 2, vorzugsweise einem Substrat aus Metall, einem sogenannten Leadframe, oder auf einem Keramiksubstrat, aufgelötet ist.

Als Material für das Leadframe wird vielfach Kupfer verwendet. Das metallische Substrat kann, muss aber nicht, mit einer zusätzlichen metallischen Schicht 3 beschichtet sein. Bei einem Keramiksubstrat hingegen ist eine metallische Schicht 3 erforderlich. Diese besteht vorzugsweise aus Kupfer, Nickel, Silber oder Gold.

Als Substrat 2 kann auch eine einlagige oder mehrlagige Leiterplatte mit einer bzw. mehreren Leiterbahnebenen dienen. Wichtig ist, dass die Leiterplatte mindestens auf die Solidustemperatur des bleifreien Lötmittels erhitzt werden kann, die beim erfindungsgemässen Lötmittel wenigstens 260° C beträgt.

Die Rückseite des Halbleiterchips 1 ist ebenfalls mit einer metallischen Schicht 4, oder mit einer Folge mehrerer Schichten, beschichtet. Als Materialien kommen dabei Gold, Silber, Nickel und Titan zur Anwendung, wobei die äusserste Schicht in der Regel aus Gold besteht.

Zur mechanischen und thermischen Kontaktierung des Halbleiterchips 1 auf dem Substrat 2 ist eine Lötmittelschicht 5 vorgesehen, die von dem erfindungsgemässen, bleifreien Lötmittel gebildet ist. Der Halbleiterchip 1 ist mittels der Lötmittelschicht 5 auf dem Substrat 2 bzw. auf der Schicht 3 des Substrats 2 befestigt.

Der Einsatz des erfindungsgemässen Lötmittels ist nicht auf die Anordnung gemäss Figur 1 beschränkt. Das erfindungsgemässe Lötmittel eignet sich allgemein zur Kontaktierung von elektrischen und elektronischen Bauelementen, insbesondere auch diskreten Bauelementen wie Dioden, Transistoren, Widerständen und dergleichen.

Besonders vorteilhaft wird das erfindungsgemässe Lötmittel zur Kontaktierung von Leistungshalbleitern eingesetzt, bei deren Betrieb eine hohe Wärmeentwicklung entsteht. Weiterhin wird das erfindungsgemässe Lötmittel zur Kontaktierung hochintegrierter Schaltungen verwendet. Dabei erfolgt die Kontaktierung derartiger Schaltungen auf Substraten beispielsweise mit Flip-Chip-Techniken, Die-attach-Techniken oder dergleichen.

Das erfindungsgemässe, bleifreie Lötmittel besteht aus einer Legierung auf Wismutbasis, wobei der Anteil von Wismut wenigstens 80 Gewichtsprozent beträgt.

Das erfindungsgemässe Lötmittel weist eine Solidustemperatur von wenigstens 260°C und vorzugsweise eine Liquidustemperatur, die unterhalb von 450°C liegt, auf.

Durch diese thermischen Eigenschaften können mit dem erfindungsgemässen Lötmittel auch Bauelemente wie Leistungshalbleiter kontaktiert werden, bei welchen grosse Wärmemengen freigesetzt werden. Das Lötmittel kann dabei mit hoher Langzeitstabilität auch bei Anordnungen von Bauelementen hoher Packungsdichte eingesetzt werden. Insbesondere werden auch integrierte Schaltungen mit einer grossen Anzahl von elektrischen Anschlüssen sicher kontaktiert.

Das erfindungsgemässe Lötmittel weist zudem gute mechanische Eigenschaften auf. Insbesondere weist die Legierung auf Wismutbasis eine hohe Festigkeit auf.

Auch hinsichtlich der thermischen Ermüdungsfestigkeit weist das erfindungsgemässe Lötmittel gute Eigenschaften auf. Weiterhin weist das erfindungsgemässe Lötmittel eine gute Benetzbarkeit, insbesondere auf Substratschichten 3 gemäss dem Ausführungsbeispiel gemäss Figur 1 auf.

Das erfindungsgemässe Lötmittel weist neben Wismut als Hauptkomponente Silber auf. Vorzugsweise beträgt der Silberanteil der Legierung zwischen 0,5 und 15 Gewichtsprozent.

Durch Variation des Silberanteils lassen sich die mechanischen Eigenschaften des erfindungsgemässen Lötmittels gezielt verändern.

Insbesondere nimmt die Verformbarkeit des Lötmittels mit steigendem Silbergehalt zu. Dabei nimmt auch die Dehnbarkeit des Lötmittels zu, wodurch letztlich auch die Scherfestigkeit, die Biegefestigkeit und die Bruchdehnung des Lötmittels erhöht wird.

Eine signifikante Verbesserung der genannten mechanischen Eigenschaften wird bei einem Anteil von wenigstens 1,5 Gewichtsprozent Silber erhalten.

Zur Optimierung der Eigenschaften des erfindungsgemässen Lötmittels, insbesondere der mechanischen Parameter werden der Legierung auf Wismutbasis zusätzlich oder alternativ zu dem genannten Silberanteil weitere Komponenten hinzugefügt.

Eine erste derartige Komponente bildet Kupfer, welches vorzugsweise mit einem Anteil bis 5 Gewichtsprozent in dem erfindungsgemässen Lötmittel enthalten ist.

Auch Zinn kann als Komponente in dem erfindungsgemässen Lötmittel enthalten sein.

Im Gegensatz zu bekannten bleifreien Lötmitteln bildet das Zinn nicht den Hauptbestandteil der Legierung, sondern ist auf einen Anteil von maximal 3% begrenzt. Durch die Begrenzung des Zinnanteils in der Legierung wird gewährleistet, dass die Solidustemperatur des Lötmittels oberhalb von 260°C liegt.

Als weitere Komponenten sind in dem Lötmittel Antimon, und/oder Zink und/oder Indium und/oder Magnesium enthalten. Der Anteil dieser Komponenten ist jeweils auf maximal 3 Gewichtsprozent begrenzt.

Als weitere Komponenten des Lötmittels können weiterhin Arsen und/oder Phosphor vorgesehen sein. Deren Anteil ist auf jeweils maximal 1 Gewichtsprozent begrenzt.

Das erfindungsgemässe Lötmittel wird zur Herstellung von Halbzeugen wie zum Beispiel Pasten, Drähten und Bändern verwendet.

Ein wesentlicher Vorteil des erfindungsgemässen Lötmittels, insbesondere bei Ausführungsformen, die neben Wismut als Hauptbestandteil auch signifikante Anteile von Silber enthalten, ist die gute Verformbarkeit.

Diese Verformbarkeit ist eine wesentliche Voraussetzung für eine Herstellung von Halbzeugen.

Für die Herstellung von Lötpasten werden aus dem Lötmittel bestehende Pulver benötigt, welche definierte Korngrössen aufweisen und welche in möglichst geringem Umfang mit Sauerstoff beladen sind. Auch hierfür ist das erfindungsgemässe Lötmittel gut geeignet.

Bei der Herstellung von Bändern wird der Anteil der Einzelkomponenten der Legierung auf Wismutbasis so gewählt, dass bei guter Verformbarkeit gleichzeitig eine hohe Festigkeit des Lötmittels erhalten wird. Die Bänder aus dem erfindungsgemässen Lötmittel sind dabei mechanisch gut beanspruchbar. Insbesondere können die Bänder gut gerollt und gebogen werden, ohne dass Bruchstellen in den Bändern auftreten.

Bei der Herstellung von Drähten werden die Anteile der Einzelkomponenten des Lötmittels so gewählt, dass die Drähte gut aufrollbar sind.

Generell wird durch eine geeignete Wahl der Komponenten des Lötmittels ein gutes Handling der damit hergestellten Halbzeuge erzielt.

## Patentansprüche

1. Bleifreies Lötmittel bestehend aus einer Legierung auf Wismutbasis mit einem Anteil von wenigstens 80 Gewichtsprozent Wismut und mit einer Solidustemperatur von wenigstens 260°C.

2. Lötmittel nach Anspruch 1, **dadurch gekennzeichnet, dass** dieses als weitere Komponente Silber enthält.

3. Lötmittel nach Anspruch 2, **dadurch gekennzeichnet, dass** dieses einen Anteil von 0,5 bis 15 Gewichtsprozent Silber enthält.

4. Lötmittel nach Anspruch 2 oder 3, **dadurch gekennzeichnet, dass** der Silberanteil wenigstens 1,5 Gewichtsprozent beträgt.

5. Lötmittel nach einem der Ansprüche 1 bis 4, **dadurch gekennzeichnet, dass** dieses als weitere Komponente Kupfer mit einem Anteil bis 5 Gewichtsprozent enthält.

6. Lötmittel nach einem der Ansprüche 1 bis 5, **dadurch gekennzeichnet, dass** dieses als weitere Komponente Antimon mit einem Anteil bis 3 Gewichtsprozent enthält.

7. Lötmittel nach einem der Ansprüche 1 bis 6, **dadurch gekennzeichnet, dass** dieses als weitere Komponente Zink mit einem Anteil bis 3 Gewichtsprozent enthält.

8. Lötmittel nach einem der Ansprüche 1 bis 7, **dadurch gekennzeichnet, dass** dieses als weitere Komponente Indium mit einem Anteil bis 3 Gewichtsprozent enthält.

9. Lötmittel nach einem der Ansprüche 1 bis 8, **dadurch gekennzeichnet, dass** dieses als weitere Komponente Magnesium mit einem Anteil bis 3 Gewichtsprozent enthält.

10. Lötmittel nach einem der Ansprüche 1 bi 9, **dadurch gekennzeichnet, dass** dieses als weitere Komponente Arsen mit einem Anteil bis 1 Gewichtsprozent enthält.

11. Lötmittel nach einem der Ansprüche 1 bis 10, **dadurch gekennzeichnet, dass** dieses als weitere Komponente Phosphor mit einem Anteil bis 1 Gewichtsprozent enthält.

12. Lötmittel nach einem der Ansprüche 1 bis 11, **dadurch gekennzeichnet, dass** dieses als weitere Komponente Zinn mit einem Anteil bis 3 Gewichtsprozent enthält.

13. Lötmittel nach einem der Ansprüche 1 bis 12, **dadurch gekennzeichnet, dass** dessen Liquidustemperatur unterhalb von 450°C liegt.

14. Verwendung des Lötmittels nach einem der Ansprüche 1 bis 13 zur Herstellung von Halbzeugen, insbesondere Drähten, Pasten und Bändern.

15. Verwendung des Lötmittels nach einem der Ansprüche 1 bis 14 zum Anlöten von elektronischen Bauelementen auf ein Substrat (2).

16. Verwendung des Lötmittels nach Anspruch 15, **dadurch gekennzeichnet, dass** die elektronischen Bauelemente von integrierten Schaltkreisen und/oder Leistungshalbleiterschaltungen gebildet sind.

17. Verwendung des Lötmittels nach einem der Ansprüche 15 oder 16, **dadurch gekennzeichnet, dass** das Substrat mit einer Schicht (3) aus Kupfer, Nickel, Silber oder Gold beschichtet ist.
